# EUROPEAN PATENT APPLICATION

(11) **EP 2 124 514 A1**
(43) Date of publication of application: **25.11.2009**
(21) Application number: 08156833.9
(22) Date of filing: 23.05.2008
(51) Int. Cl.: H05K 3/10

(54) **Providing a plastic substrate with a metallic pattern**

(71) Applicant: Nederlandse Centrale Organisatie Voor Toegepast Natuurwetenschappelijk Onderzoek TNO, 2628 VK Delft (NL)
(72) Inventor: Meinders, Erwin Rinaldo, 5508 WB Veldhoven (NL); Peter, Maria, 5658 GE Eindhoven (NL); Furthner, Francois, 5644 GJ Eindhoven (NL); Tacken, Roland Anthony, 5663 SH Geldrop (NL)
(74) Representative: Hatzmann, Martin

(57) **Abstract**

The invention is directed to a method of providing a plastic substrate (1) with a metallic pattern (8) and to a plastic substrate (1) with a metallic pattern (8) obtainable by said method.
The method of the invention comprises
i) replicating a pattern of recesses and protrusions on a plastic substrate (1) by pressing a stamp having recesses and protrusions against the substrate, thereby providing said plastic substrate (1) with recesses and protrusions;
ii) removing said stamp from said substrate;
iii) - providing a layer of seed material (2) capable of initiating an electroless or electrochemical metal deposition process onto said plastic substrate at least in the recesses of said plastic substrate;
- optionally providing a layer of inhibitor material on top of or below said layer of seed material (2); and
- if necessary, etching excess seed material (2) and/or excess inhibitor material (3),
to yield a substrate wherein said seed material (2) and/or said inhibitor material (3) remains selectively in the recesses or on the protrusions of said substrate; and thereafter
iv) using said seed material (2) to initiate a metal deposition process.

## Description

The invention is directed to a method of providing a plastic substrate with a metallic pattern and to a plastic substrate comprising a metallic pattern obtainable by said method.

Substrates having electrically conductive micro-patterns thereon are used in a wide variety of electronic applications. Glass substrates used for LCDs, touch screens for visual displays, and consumer electronic displays all require electrically conductive lines to be formed thereon to provide the desired functionality. Also flexible plastic substrates provided with a metallic pattern have high potential as electronic circuits and electrodes. In particular, plastic substrates having conductive micro-patterns thereon can be used in electronic applications, such as flexible displays, rollable displays, smart blisters, radiofrequency identification (RFID) tags, smart labels, electrode arrays for bio-sensing and other sensor applications with distributed transistors, pressure sensors, *etc*.

Typically, the micro-patterns formed on a glass or silicon substrate are prepared by a process which comprises a metal deposition step followed by a photolithography step. When a plastic substrate is used, it is difficult to form a metallic micro-pattern directly on the surface of the plastic due to its dimensional instability and deformability caused by a high thermal expansion coefficient and by moisture loss or uptake, and its sensitivity to organic solvents and weak interaction between plastic surface and metal pattern, and accordingly, a screen-printing or electroplating method has conventionally been used, see for instance US-A-6 030 515. However, such a screen-printing method has limited resolution and defect level sensitivity. Patterning plastic substrates by electroplating requires a pre-deposited, eventually pre-patterned seed layer or post-patterning *e.g.* by photolithography.

Another method is described in US-A-2003/0 024 632, which uses a reactive metal micro-pattern on the surface of an inorganic substrate as a stamper to provide a plastic substrate with a metal micro-pattern by transfer printing. Disadvantages of this method are that many expensive and time consuming manufacturing steps are involved: metal deposition on the inorganic substrate, the definition of micro-patterns on the inorganic substrate by photolithography, surface treatment/activation of the plastic substrate, pattern transfer by contact printing. These steps give rise to many defects. In addition, this method is incompatible with roll-to-roll manufacturing.

US-A-5 830 533 describes a method in which a seed layer is deposited on a dielectric substrate. The seed layer is overlaid with a patterned photoresist mask and then exposed portions of the seed layer are etched away. Then the photoresist mask is removed thereby exposing the unetched portions of the seed layer. Finally, the unetched portions of the seed layer are used to deposit metal on the dielectric substrate *e.g*. by electroless deposition. Disadvantage of this method is that the use of a mask is expensive.

US-A-2004/0 187 310 describes a method according to which the surface of an imprinting stamp is coated with a seed layer. The seed layer is then transferred to a substrate by micro-contact imprinting, after which the seed layer can be used for metal deposition. The seed layer is not provided on the substrate in a selective way and therefore this method requires removal of seed layer from regions of the substrate where seeding is not needed, *e.g*. by grinding. In addition, this is a soft-imprint step (micro-contact printing). Also in this case, the resolution is limited and it is difficult to assure total/defectless seed transfer.

Accordingly, there remains an existed need for developing an improved and cost-effective method for forming a high resolution metal micro- or even nano-pattern on a plastic substrate. Also, the compatibility with roll-to-roll manufacturing for the desired resolution is lacking in the prior art.

Object of the invention is to provide a method for providing a plastic substrate with a metallic pattern, which method at least partly overcomes the disadvantages faced in the prior art.

Further object of the invention is to provide a method for providing a plastic substrate with a metallic pattern, which method is relatively easy and results in a plastic substrate having an accurate conductive metal pattern thereon. In addition, it would be highly advantageous if the method is cost-effective and compatible with roll-to-roll processing.

The inventors found that one or more of these objects can be met by providing a method in which a pattern is first replicated in the plastic substrate and subsequently seed material is provided on the pattern in a selective fashion. The patterned seed material is then subsequently used to deposit metal in a controlled manner.

Accordingly, the invention is directed to a method of providing a plastic substrate with a metallic pattern comprising
i) replicating a pattern of recesses and protrusions on a plastic substrate by pressing a stamp having recesses and protrusions against the substrate, thereby providing said plastic substrate with recesses and protrusions;
ii) removing said stamp from said substrate;
iii) providing a layer of seed material capable of initiating an electroless or
   electrochemical metal deposition process onto said plastic substrate at least in the recesses of said plastic substrate;
   - optionally providing a layer of inhibitor material on top of or below said layer of seed material; and
   - if necessary, etching excess seed material and/or excess inhibitor material,
      to yield a substrate wherein said seed material and/or said inhibitor material remains selectively in the recesses or on the protrusions of said substrate; and thereafter
iv) using said seed material to initiate a metal deposition process.

The inventors found that this method has high potential, because it yields plastic substrates with highly accurate metallic patterns. In addition, the method of the invention allows cost-effective manufacturing of high accuracy, well defined metal patterns at different length scales, and is compatible with roll-to-roll processing.

The term "pattern" as used in this application is meant to refer to a geometric arrangement of features. The features can *e*.*g*. be lines, squares, circles, dots, any other shapes, or combinations thereof.

The term "recess" as used in this application is meant to refer to any shape extending inward from the plane of the surface, *e.g*. a trench. It is not intended to limit the dimension or shape of the recess.

The term "protrusion" as used in this application is meant to refer to any shape extending outward from the plane of the surface. It is not intended to limit the dimension or shape of the protrusion.

In case a substrate surface has recesses, then the parts of said substrate surface not forming said recesses inherently form protrusions. Similarly, in case a substrate surface has protrusions, then the parts of said substrate surface not forming said protrusions inherently form recesses.

The plastic substrate can be any polymer substrate, such as polyesters like polyethylenenaphthalate (PEN) and polyethyleneterephthalate (PET), polyimide (PI), polymethylmethacrylate (PMMA), polycarbonate (PC), polyamide (PA), polyethersulphones (PES), polydimethylsiloxane, polyepoxides, polyolefins, polyarylates, or the like, or fibre reinforced polymers. The substrate can be thin such that it becomes flexible or even stretchable. The substrate can be self-supporting or may be supported by a rigid carrier such as glass, silicon, metal, a thick polymer, *etc*. The term substrate is meant to include layers applied on the plastic, such as an imprint layer coated on the plastic material. Thus, the plastic substrate can comprise an imprint layer. Such an imprint layer may for instance be thermally curable (including thermoplastic polymers which become fluid above their melting temperature and solidify below their glass transition temperature, such as polyimide (PI), polymethyl methacrylate (PMMA), polystyrene (PS), and the like) and/or ultraviolet (UV) curable (including epoxies (such as SU8 described in US-A-4 882 245), acrylates, and the like). If the substrate comprises an imprint layer the recesses and protrusions are preferably provided into said imprint layer.

According to one step of the method of the invention a pattern of recesses and protrusions is replicated on a plastic substrate by pressing a stamp having recesses and protrusions against the substrate, thereby providing said plastic substrate with recesses and protrusions. The stamp can be a regular stamp or a template, but also a mould (replica from the stamp/template). The stamp or mould can be made out either of a rigid material or a soft polymeric material. Suitable methods for replicating a pattern on a substrate for instance include hot embossing, injection moulding, UV curing, phase-separation or the like. In case the substrate comprises an imprint layer, the stamp or mould is preferably pressed against the surface of the substrate on which the imprint layer is applied.

Thus, in an embodiment the stamp or mould is pressed against a surface of the substrate at a temperature which is higher than the glass transition temperature of the plastic material of said substrate, thereby providing the substrate with recesses and protrusions. In case the substrate comprises an imprint layer, the stamp can be pressed against the substrate at a temperature which is higher than the glass transition temperature of said imprint layer.

It is also possible that the stamp or mould is pressed a surface of the substrate at a temperature which is higher than the melting temperature of the plastic material of said substrate, thereby providing the substrate with recesses and protrusions. In case the substrate comprises an imprint layer, the stamp can be pressed against the substrate at a temperature which is higher than the melting temperature of said imprint layer.

In case the substrate comprises a UV curable imprint layer, a transparent stamp or mould (such as a stamp or mould made of quartz, polydimethylsiloxane (PDMS), or the like) can be pressed against a surface of the substrate followed by curing with UV irradiation through said stamp or mould. In further embodiment, the substrate excluding said imprint layer is transparent and the imprint layer can be cured with UV irradiation through the substrate. It is also possible to simultaneously press the stamp or mould onto a surface of the substrate and irradiate the imprint layer with UV irradiation.

In case the substrate comprises a thermally curable liquid-like imprint layer, pressing the stamp onto a surface of the substrate may be followed by a heating step in which the imprint layer is cured. This heating step may also be carried out simultaneously with pressing the stamp or mould onto a surface of the substrate.

In a special embodiment, the substrate comprises an imprint layer that comprises at least two polymeric components and while pressing the stamp or mould against the substrate, a vertical phase separation of the at least two polymers is induced. The phase-separation results in solidification of the two phases such that a structured surface remains.

In a preferred embodiment of the invention, the recesses and/or protrusions of the stamp or mould comprise micro- and/or nanostructures. It is particularly preferred that the recesses and protrusions of the stamp have a different surface roughness and are able to provide the substrate with recesses and protrusions having different wetting properties. The substrate can thus be provided with recesses and/or protrusions that are hydrophobic or hydrophilic. Preferably, the recesses are rendered hydrophobic and the protrusions are rendered hydrophilic or *vice versa*. In this case it is highly advantageous that the stamp surface which is to be pressed against the plastic substrate (optionally comprising an imprint layer) is micro-machined in such a way that the replication step already results in protrusions and recesses having different wetting properties due to roughness differences.

After the stamp or mould has been pressed against the plastic substrate the stamp or mould is removed from the substrate, thus leaving a patterned plastic substrate.

Thereafter, a layer of seed material capable of initiating an electroless or electrochemical metal deposition process is provided onto the plastic substrate at least in the recesses of the plastic substrate. The purpose of the seed material is to deposit a thin, conductive layer or film to act as an initiator for an electroless or electrochemical metal deposition process. The seed material can be a curable material, such as thermally curable or UV curable. In an embodiment the seed material comprises nanoparticles (comprising elements selected from the group consisting of Ag, Au, Cu, Fe, Ni, Pd, Pt, Sn, Co, light or heat sensitive organic molecules, inks, organometallic compounds, metal salts, and metal sulphides. Suitable metals for the seed layer include Cr, Al, Au, Cu, Ni, Ag, Pd, Ru, Pt, W, and Ti. Suitable non-metals include conducting polymers, *e.g*. polyaniline or polypyrrole, conducting powders, and enzymes.

The seed material may be applied as a continuous layer, but preferably the seed material is applied as a selective pattern. The seed material is preferably applied directly onto the plastic substrate, which is provided with recesses and protrusions. In case the plastic substrate comprises an imprint layer, the seed material is preferably applied directly onto the imprint layer, which is provided with recesses and protrusions. Optionally, an adhesion promoter or promoting treatment can be applied between the substrate and the layer of seed material to improve the adhesion of the seed material on the substrate. Such adhesion promoters are well-known in the art and include *e.g*. plasma treatment, UV/ozone treatment, self-assembled monolayers (alkyl or aryl chlorosilanes, alkoxysilanes, Langmuir-Blodgett films, and the like, having one or more reactive functional groups such as -OH, -NH₂, -COOH, capable of promoting the adhesion of a third material), polymer coatings, any organic or inorganic coating that has a higher surface energy than the substrate thereby promoting the adhesion of the seed (examples thereof include silane compounds, such as aminopropyltriethoxysilane (APTES)or alkyl or aryl chlorosilanes, alkoxysilanes, Langmuir-Blodgett films, and the like, having one or more reactive functional groups such as -OH, -NH₂, -COOH, capable of promoting the adhesion of a third material.

The seed material may be applied onto the substrate by spin-coating. If the seed material is to be applied in a selective pattern then spin-coating can be followed by an isotropic etch step. This means that the etching process propagates in the same way and/or rate in each direction. The etching step can be a wet or dry etching step. During the etching step excess seed is removed from the protrusions of the substrate, while seed material is left in the recesses of the substrate.

Another way of applying the seed material onto the substrate is by printing, such as inkjet printing, gravure printing, or offset printing. The seed material may comprise a UV curable component which can be cured during or after printing in the desired areas, *e*.*g*. by using ultraviolet radiation through a mask. Another option is to use optical interference curing, according to which two interfering light beams cure the ink in the areas where the intensity of the light is sufficiently high due to positive interference. It is also possible to cure the ink locally using a focussed laser beam, preferably a UV laser beam. Another possibility is curing the ink using a two-photon polymerisation process. Uncured seed material can thereafter be washed off.

Other ways of applying the seed material are dip-coating or conventional metal film deposition techniques (evaporation, sputtering, vapour deposition (chemical or physical), plasma enhanced deposition and the like). Normally, metal deposition is preferred to dip-coating, as it gives better quality layer.

In a preferred embodiment, the recesses and the protrusions in or on the surface of the plastic substrate have different wetting properties. The recesses or the protrusions may for instance selectively be rendered hydrophilic, for example by introducing an appropriate surface roughness using a micro- and/or nanostructured stamp or mould (also known as micro- or nano-machining). The seed material can then be deposited selectively into said recesses or onto protrusions due to the different wetting properties of the recesses and protrusions of the substrate surface.

In another preferred embodiment, a difference in wetting properties of the recesses is introduced or enhanced by chemical or physical surface modification or functionalisation. In an embodiment, the above-mentioned micro-machining is combined with a chemical surface modification, such as the introduction of hydrophilic (e.g. -OH, -NH₂, -COOH, *etc*.) or hydrophobic groups on the substrate surface (-CH₃, -CF₃, *etc*.).

As an optional step, it is possible to apply an inhibitor material either on top of, or below the layer of seed material. Thus, the inhibitor material can be applied to the substrate before the layer of seed material is applied, but also thereafter. The inhibitor material inhibits the electroless or electrochemical metal deposition in areas where it is deposited. Suitable examples of inhibitor material include materials that are known to inhibit or stabilise electroless deposition processes, *e.g*. heavy metal ions, organic and inorganic sulphur-, selenium or tellur- containing compounds, oxygen containing compounds and aliphatic and unsaturated organic compounds. Preferably, the inhibiting material comprises thiourea, dodecanethiol, dipyridyl, lead acetate, maleic acid or 2-mercaptobenzothiazole.

The layer of inhibiting material can suitably be an incompletely adsorbed surface coverage, an adsorbed monolayer or a multilayer, or a closed film or coating.

The inhibitor material is normally applied on a continuous seed layer, preferably directly thereon. The inhibitor material is preferably applied as a selective pattern. Typically, the inhibitor material is applied on the layer of seed material using similar techniques as mentioned hereinabove for the seed material.

Spin-coating and printing (ink jet printing, gravure printing, screen printing, offset printing *etc*.) of the inhibitor material results in a top-coating of inhibitor material which is thicker at the recesses of the substrate surface and thinner at the protrusions of the substrate surface.

Since the layer of inhibitor material is preferably applied as a selective pattern, application of the inhibitor material is preferably followed by an isotropic etching step (dry or wet) to remove excess inhibitor material from the protrusions, resulting in unprotected seed material that can initiate electroless or electrochemical metal deposition. An adhesive type material might also be used to remove the excess inhibitor from the undesired areas.

It is also possible to apply the inhibitor material by dip coating or vapour depositing. These techniques result in a top-coating of inhibitor material having a homogeneous thickness. Thereafter excess inhibitor material can be locally etched off by dry etching through a mask or by using laser ablation or thermal ablation. This allows for etching of inhibitor material selectively from the recesses, or from the protrusions.

In a preferred embodiment, the recesses or the protrusions in or on the surface of the plastic substrate have different wetting properties. The recesses or the protrusions may for instance selectively be rendered hydrophilic, for example by introducing an appropriate surface roughness using a micro- or nanostructured stamp or mould. The inhibitor material can then be deposited selectively into said recesses or onto protrusions due to the different wetting properties of the recesses and protrusions of the substrate surface. An additional etching step in this case becomes unnecessary.

In an embodiment the inhibitor material is deposited selectively on the protrusions of the substrate surface using a roller, a flat (meaning without structures or patterns) stamp, or a flat substrate inked or coated with the inhibitor material resulting in local de-activation of the seed layer on the protrusions. Also in this case an additional etching step is unnecessary.

The application of the seed material and optionally of the inhibitor material is performed such that a substrate is yielded wherein the seed material and/or the inhibitor material remains selectively in the recesses or on the protrusions of the substrate. In certain cases this may require etching of excess seed material and/or excess inhibitor material.

In a further step the substrate is subjected to electroless or electrochemical metal deposition process in order to metallise the exposed pattern of seed material. Suitable metal deposition processes for instance include electroless plating (such as electroless copper, nickel, nickel-phosphorous or nickel-boron, silver, tin or gold plating), and electrochemical deposition or plating of metals.

Typically, the electroless or electrochemical metallisation involves the use of organic or inorganic electrolytes (salts dissolved in organic solvents or in water) and/or ionic liquids. Ionic liquids comprise molten salts, in particular salts that are liquid below 100 °C. The cations of the ionic liquid can for instance be selected from the group consisting of monosubstitued imidazolium, disubstituted imidazolium, trisubstituted imidazolium, pyridinium, pyrrolidinium, phosphonium, ammonium, guanidinium, tri-substituteted sulphonium and isouronium, or derivatives thereof. The anions of the ionic liquid can for instance be selected from the group consisting of chloride, bromide, iodide, nitrate, nitrite, fluoride, phosphate, imide, amide, borate, tosylate, tetrafluoroborate, hexafluoroborate, hexafluorophosphate, trifluoromethanesulphonate, methylsulphate, bis(pentafluoroethyl)phosphinate, thiocynate, octylsulphate, hexylsulphate, butylsulphate, ethylsulphate, dicyanamide, hexafluoroantimonate, bis-(pentafluoroethyl)phosphinate, bis-(triffuoromethyl)imide, trifluoroacetate, bis-trifluorosulphonimide, and dicyanamide.

Optionally, the method of the invention may be followed by a step in which the layer of inhibitor material and/or the layer of seed material are removed from non-metallised areas of the plastic substrate.

The method of the invention can advantageously be performed in a roll-to-roll fabrication method, because thin plastic substrates can be processed from a roll while unwinding, processing and rewinding. Conventional methods in which rigid substrates are used, are not suitable for roll-to-roll fabrication.

In order to preserve the aspect ratio of the structures (defined as the ratio between the height and lateral dimensions) through the whole process, a grid of finger structures can be used at the bottom of the recesses. Large area parts of the substrate are covered with a grid of recesses such that the aspect ratio is not sacrificed. In this case, the seed layer is patterned according to the method of the invention. The finer grid prevents levelling of the seed layer, and thus the absence of patterning.

In a further aspect, the invention is directed to a plastic substrate with a metallic pattern obtainable by the method of the invention. Such substrates can suitably have submicron structures and can advantageously be used in embedded conductors.

In yet a further aspect the invention is directed to an electronic device comprising the plastic substrate with a metallic pattern of the invention. Suitable examples of such a device include an electrode array, flexible displays, rollable displays, smart blisters, radiofrequency identification (RFID) tags, smart labels, electrode arrays for bio-sensing and other sensor applications with distributed transistors, pressure sensors, wearable devices, *etc.*

The invention will now be illustrated by means of the following specific embodiments which are not meant to limit the invention in any way, and which may optionally be combined.

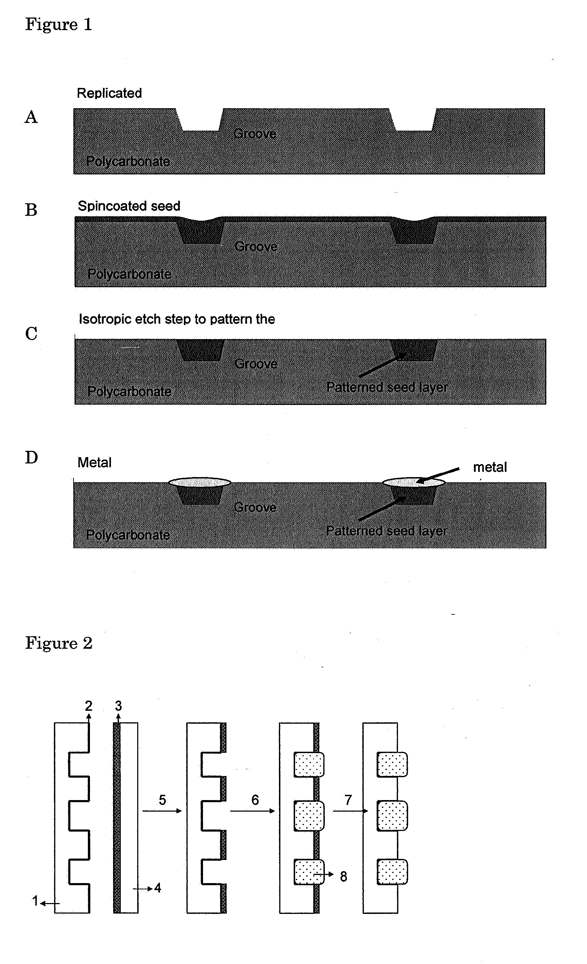

In a first embodiment, the method of the invention can be used to prepare a metallic pattern on a plastic substrate by a method comprising the following steps. This embodiment is illustrated in Figure 1, wherein the plastic substrate is polycarbonate and the recesses are indicated as grooves.

A pattern of recesses and protrusions is replicated in a plastic substrate. The replicated pattern consists of a grid of recesses with a predefined shape. The remaining parts of the substrate inherently become protrusions. The aspect ratio (ratio of height to width) of the features is typically larger than one, but can also be smaller than 1.

The substrate with the replicated pattern is then covered with a spin-coated layer of seed material. The spin-coating process results in a non-uniform layer distribution. The protrusions are typically covered with less seed material than the recesses.

An etching step is applied to partially remove the spin-coated layer. The spin-coated seed material located on the protrusions is typically fully washed away, while the seed material in the recesses remains there. This process results in a patterned seed layer. Removal of excess spin-coated seed material from the protrusions can also be performed using a PDMS flat stamp, or any weaker adhesive tape, to which the surface seed will adhere upon contact and can be removed without removing the seeds from the recesses, or by isotropic etching. The substrate with the patterned layer of seed material is used in an electroless or electrochemical metal deposition process such that a patterned metal is deposited on the substrate.

In a second embodiment a layer of inhibitor material is used to prevent electroless growth in the desired areas.

A pattern of recesses and protrusions is replicated in a plastic substrate. The replicated pattern consists of a grid of recesses with a predefined shape. The remaining parts of the substrate inherently become protrusions. The aspect ratio (ratio of height to width) of the features is typically larger than one.

The substrate with the replicated pattern is then uniformly coated with seed material. Thereafter inhibitor material is spin-coated on the substrate and the inhibitor material settles in the recesses.

An isotropic etch step partially removes the inhibitor so that it is selectively present in the recesses, allowing growth outside the recesses. Thereafter, electroless or electrochemical metal deposition can be performed. Finally, inhibitor material as well as the underlying seed material can be removed from the recesses.

In a third embodiment a layer of inhibitor material is used to prevent electroless growth in the desired areas. This embodiment is illustrated in Figure 2.

A pattern of recesses and protrusions is replicated in a plastic (such as polycarbonate) substrate. The replicated pattern consists of a grid of recesses with a predefined shape. The remaining parts of the substrate inherently become protrusions. The aspect ratio (ratio of height to width) of the features is typically larger than one.

The substrate with the replicated pattern (1) is then uniformly coated with seed material (2). The layer of seed material can for instance be a copper layer of about 50 nm thick, which is provided by sputtering.

A hard material, such as steel, body (4) is coated with inhibitor material (3). The plastic substrate (1) is then pressed against the hard material body (4), such that the layer of seed material (2) is in contact with the layer of inhibitor material (3). Thereby inhibitor material (3) deposits on the layer of seed material (2) at the areas of contact (typically the protrusions of the plastic substrate surface).

During electroless or electrochemical metal deposition (6) a metal (8), such as Au, will grow only in the recesses where the seed material (2) is not covered by inhibitor material (3).

Inhibitor material and seed material can then be etched from the upper surface (7), which leaves recesses with the deposited metal (8).

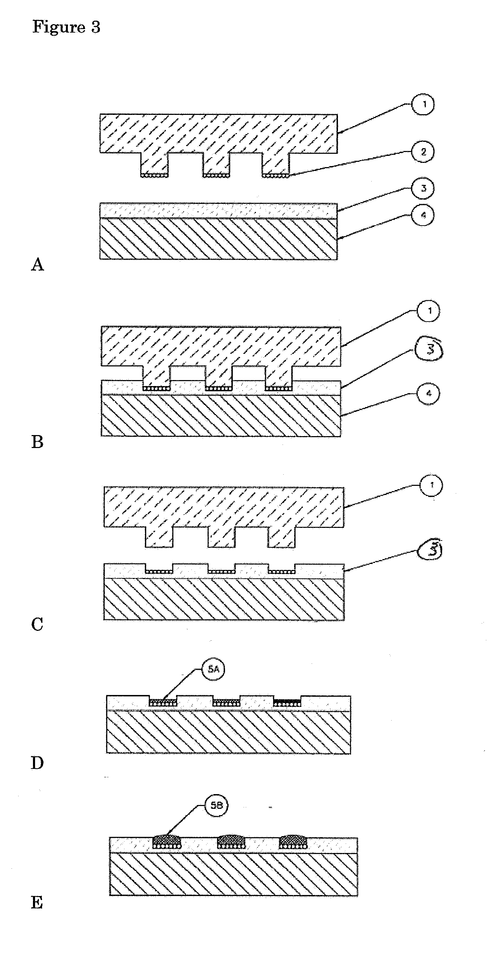

In a fourth embodiment a pattern is replicated in a substrate coated with an imprint layer. This embodiment is illustrated by Figure 3.

A patterned stamp (1) (having protrusions and recesses) is inked with seed material (2) capable of initiating an electroless or electrochemical metal deposition process. The stamp can be inked such that seed material selectively adheres onto the protrusions (*e*.*g*. by dipping the stamp before imprinting in a molten metal such as Sn or Pb, or metal salt). The stamp is then pressed against a plastic substrate (4) comprising an imprint layer (3). Pressing the stamp (1) against the imprint layer (3) can be accompanied by heating. The replication results in a substrate comprising recesses and protrusions in said imprint layer, wherein selectively the recesses are provided with seed material.

After removal of the stamp the seed material adheres to the surface of the recesses of the substrate. The plastic substrate (1) is then subjected to electroless or electrochemical metal deposition. Depending on the deposition time thinner highly conductive structures (5A) or thicker highly conductive structures (5B) will form. These structures can serve as electrodes or other parts of an electric circuit.

In a fifth embodiment, micro- and/or nanostructures are utilised to enable selective wetting of surfaces depending on pattern structures and sizes.

A stamp is provided with micro- and/or nanostructured areas, for instance the protrusions of the stamps are nanostructured via a laser ablation process. This stamp is used for replicating in a plastic substrate, optionally comprising an imprint layer. This replication step provides the plastic substrate with the micro- and/or nanostructures. Typically, the micro- and/or nanostructures are such that they influence the wetting properties such that the resulting recesses and/or protrusions of the plastic substrate have different wetting properties. This difference in wetting properties is then used to pattern a layer of seed material. In a final stage, the deposited seed material is used to initiate an electroless or electrochemical metal deposition process.

## Claims

1. Method of providing a plastic substrate with a metallic pattern comprising
i) replicating a pattern of recesses and protrusions on a plastic substrate by pressing a stamp having recesses and protrusions against the substrate, thereby providing said plastic substrate with recesses and protrusions;
ii) removing said stamp from said substrate;
iii) providing a layer of seed material capable of initiating an electroless or
electrochemical metal deposition process onto said plastic substrate at least in the recesses of said plastic substrate;
- optionally providing a layer of inhibitor material on top of or below said layer of seed material; and
- if necessary, etching excess seed material and/or excess inhibitor material,
to yield a substrate wherein said seed material and/or said inhibitor material remains selectively in the recesses or on the protrusions of said substrate; and thereafter
iv) using said seed material to initiate a metal deposition process.

2. Method according to claim 1, wherein said plastic substrate comprises a thermally and/or UV curable imprint layer, and wherein said recesses and protrusions are provided into said imprint layer.

3. Method according to claim 2, wherein said layer of seed material is provided directly onto said imprint layer.

4. Method according to claim 1, wherein said stamp is pressed against the substrate at a temperature higher than the glass transition temperature and/or higher than the melting temperature of said plastic substrate.

5. Method according to claim 2 or 3, wherein said stamp is pressed against the substrate at a temperature higher than the glass transition temperature and/or higher than the melting temperature of said imprint layer.

6. Method according to claim any one of claims 2-5, wherein said imprint layer is UV curable and said stamp and/or said substrate is transparent.

7. Method according to claim any one of claims 2-6, wherein said replication is followed by a curing step to cure said thermally and/or UV curable imprint layer comprising applying heat and/or UV irradiation to said imprint layer.

8. Method according to any one of the preceding claims, wherein said pressing induces vertical phase separation of at least two polymers comprised in said substrate.

9. Method according to any one of the preceding claims, comprising said step of etching excess seed material and/or excess inhibitor material.

10. Method according to any one of the preceding claims, wherein the recesses and/or protrusions of said stamp comprise micro- and/or nanostructures and wherein the recesses and protrusions of said stamp have different surface roughness, thereby providing the recesses and protrusions of said substrate with different wetting properties.

11. Method according to any one of the preceding claims, wherein said layer of seed material is a continuous layer.

12. Method according to any one of the preceding claims, wherein said layer of seed material is curable and at least part of said seed material is cured after being provided onto said substrate.

13. Method according to claim 12, wherein uncured seed material is removed after curing said layer of seed material.

14. Method according to any one of the preceding claims, wherein said layer of seed material and/or said layer of inhibitor material is provided by a method selected from the group consisting of spin-coating, squeegee-based filling, printing, dip coating, vapour deposition, evaporation, sputtering, and plasma enhanced deposition.

15. Method according to any one of the preceding claims, further comprising a step wherein said layer of inhibitor material and/or said layer of seed material are removed from non-metallised areas of said substrate.

16. Method according to any one of the preceding claims, wherein said seed material comprises one or more selected from nanoparticles, light or heat sensitive organic molecules, inks, organometallic compounds, metal salts, conductive polymers, conducting powders, and enzymes.

17. Method according to any one of the preceding claims performed in a roll-to-roll fabrication method.

18. Plastic substrate comprising a metallic pattern obtainable by a method according to any one of the previous claims.

19. Electronic device comprising the plastic substrate of claim 18.
